(19) **Europäisches Patentamt / European Patent Office / Office européen des brevets**

(11) **EP 4 481 812 A1**

(12) **EUROPEAN PATENT APPLICATION**

(43) Date of publication:
**25.12.2024 Bulletin 2024/52**

(21) Application number: **23180220.8**

(22) Date of filing: **20.06.2023**

(51) International Patent Classification (IPC):
**H01L 23/552** (2006.01)    **H01L 23/66** (2006.01)

(52) Cooperative Patent Classification (CPC):
**H01L 23/552;** H01L 23/66; H01L 2223/6677;
H01Q 1/2283

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Infineon Technologies AG**
**85579 Neubiberg (DE)**

(72) Inventors:
• **KORNPROBST, Simon**
**83071 Stephanskirchen (DE)**
• **ERDÖL, Tuncay**
**82008 Unterhaching (DE)**
• **HARTNER, Walter**
**93077 Bad Abbach (DE)**

(74) Representative: **Infineon Patent Department**
**Intellectual Property**
**Infineon Technologies AG**
**Postfach 22 16 44**
**80506 München (DE)**

(54) **RADIO FREQUENCY SEMICONDUCTOR DEVICE AND METHOD FOR FABRICATING A RADIO FREQUENCY SEMICONDUCTOR DEVICE**

(57) According to an example of the invention, a radio frequency (RF) semiconductor device to process RF signals in an operating frequency range comprising a semiconductor chip comprising a first surface, a second surface, sidewalls and an active chip region. The first surface and second surface extend along a lateral direction and the sidewalls extend along a vertical direction.

Figure 7

EP 4 481 812 A1

## Description

### TECHNICAL FIELD

The present disclosure relates to a radio frequency semiconductor device and in particular to a radio frequency semiconductor device with a metal layer. In addition, the present disclosure relates to method of manufacturing such devices.

### BACKGROUND

In the area of advanced driver assistant systems (ADAS), RF semiconductor devices play a crucial role. To improve the performance and functionality of the RF semiconductor devices, more and more functionalities are packed into components with small packages leading to an electromagnetic interference (EMI) coupling between the electrical circuits and other components of the RF semiconductor devices. As RF semiconductor devices are becoming smaller and tightly packed, they are also more vulnerable to the EMI.

Accordingly, it is an object of this application to provide a concept for an RF semiconductor device which reduces the electromagnetic interference in the RF semiconductor device. This object is solved by an RF semiconductor device according to claim 1 and a method of fabricating a radio frequency semiconductor device according to claim 19.

### SUMMARY

According to an example of the invention, a radio frequency (RF) semiconductor device to process RF signals in an operating frequency range comprises a semiconductor chip comprising a first surface, a second surface, sidewalls and an active chip region. The first surface and second surface extend along a lateral direction and the sidewalls extend along a vertical direction. A metal layer is provided external to the active chip region, wherein the metal layer faces the second surface of the semiconductor chip, wherein the metal layer has a thickness that is below a skin depth corresponding to the operating frequency range.

According to an example of the invention a method for a radio frequency (RF) semiconductor device to process RF signals in an operating frequency range comprises:

- providing a semiconductor chip comprising a first surface, a second surface, sidewalls and an active chip region, the first surface and second surface extending along a lateral direction and the sidewalls extending along a vertical direction,

- providing a metal layer external to the active chip region, wherein the metal layer faces the second surface of the semiconductor chip, wherein the metal layer has a thickness that is below a skin depth corresponding to the operating frequency range.

Those skilled in the art will recognize additional features and advantages upon reading the following detailed description, and upon viewing the accompanying drawings.

### BRIEF DESCRIPTION OF THE DRAWINGS

The present disclosure is illustrated by way of example, and not by way of limitation, in the figures of the accompanying drawings in which like reference numerals refer to similar or identical elements. The elements of the drawings are not necessarily to scale relative to each other. The features of the various illustrated examples can be combined unless they exclude each other.

Fig. 1 illustrates a cross-sectional view of an RF semiconductor device.
Fig. 2 illustrates a cross-sectional view of an RF semiconductor device.
Fig. 3 illustrates a cross-sectional view of an RF semiconductor device.
Fig. 4 illustrates a cross-sectional view of an RF semiconductor device.
Fig. 5 illustrates a cross-sectional view of an RF semiconductor device.
Fig. 6 illustrates a cross-sectional view of an RF semiconductor device.
Fig. 7 illustrates a cross-sectional view of an RF semiconductor device.
Fig. 8 illustrates a cross-sectional view of an RF semiconductor device.
Fig. 8A illustrates a cross-sectional view of an RF semiconductor device.
Fig. 9 illustrates a cross-sectional view of an RF semiconductor device.
Fig. 10 illustrates a cross-sectional view of an RF semiconductor device.
Fig. 11 illustrates an experimental measurement of reflection, transmission, and absorption of a metal layer.

### DETAILED DESCRIPTION

In the following description, directional terminology, such as "top", "bottom", "upper", "lower" "front", "back" etc., is used with reference to the orientation of figures being described. The components of the disclosure can be positioned in a number of different orientations, the directional terminology is used for purposes of illustration and is in no way limiting.

Furthermore, to the extent that the terms "include", "have", "with" or other variants thereof are used in either the detailed description or the claims, such terms are intended to be inclusive in a manner similar to the term "comprise". The terms "coupled" and "connected", along with derivatives thereof may be used. It should be understood that these terms may be used to indicate that two elements co-operate or interact with each other regardless of whether they are in direct physical or electrical contact, or they are not in direct contact with each other; intervening elements or layers may be provided between the "bonded", "attached", or "connected" elements.

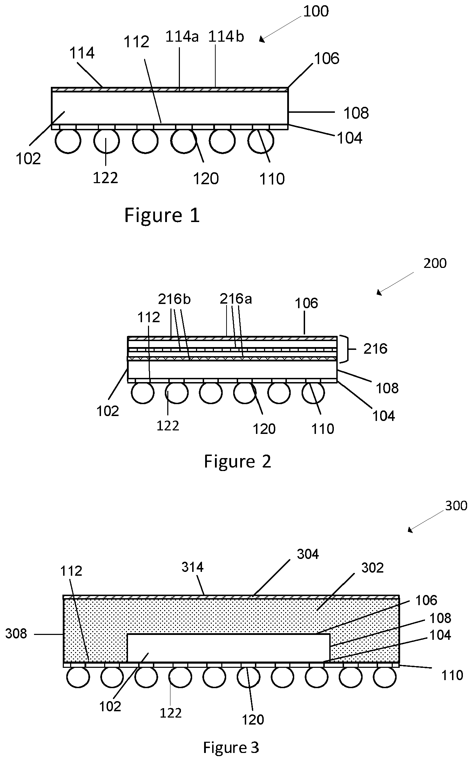

Figure 1 shows a cross sectional view of a radio frequency (RF) semiconductor device 100. The RF semiconductor device 100 has a semiconductor chip 102 configured to operate in a predetermined frequency range such as a millimeter-wave frequency range, for example in a first frequency range from 1 GHz to 500 GHz or in a second frequency range from 60 GHz to 90 GHz. In some examples, the semiconductor chip 102 may correspond to a radar chip and may be used as a transmitter, a receiver, a sensor, a detector etc. In other examples the semiconductor chip may be a 5G or 6G communication chip, a high data transfer communication system, wireless backhaul systems of body scanning systems for security. The RF signal or RF signals refer to the RF signal or RF signals in the operating frequency range.

The semiconductor chip 102 has a first surface 104, a second surface 106 opposite to the first surface 104 and sidewalls 108. The first surface 104 and the second surface 106 may be referred to as a first main surface and a second main surface. The first surface 104 and second surface 106 extend along a lateral direction and the sidewalls 108 extend along a vertical direction. An active chip area having transistors and other circuit elements is provided in the semiconductor chip 102. The active chip area may be capable of generating and analyzing RF signals and other signals. In some examples, the active chip area may also be referred as an RF chip circuitry.

The first surface 104 of the semiconductor chip 102 is arranged on a first side 112 of a redistribution layer 110 and an electrical contact is established between the semiconductor chip 102 and electrically conductive structures of the redistribution layer 110. For example, the electrical contact may be formed by a bond pad which may be made of aluminum and/or copper. This allows the RF signals to be transmitted from the semiconductor chip 102 to the electrical contacts and/or vice-versa. In the implementation of Figure 1, the RF semiconductor device 100 may correspond to a wafer level package.

The semiconductor chip 102 may have a thickness selected from a range of 100 $\mu$m to 1000 $\mu$m, wherein the thickness is measured between the first surface 104 and the second surface 106 of the semiconductor chip 102. In some examples the semiconductor chip 102 may have the thickness selected in a range of 50 $\mu$m to 400 $\mu$m. In some examples, the thickness of the semiconductor chip 102 can also be measured between the first side 112 of the redistribution layer 110 and the second surface 106 of the semiconductor chip 102.

The redistribution layer 110 may have one or more electrically conductive structures in form of metal lines or metal planes, running parallel to the first surface 104 of the semiconductor chip 102. The electrically conductive structures route the electric current in the RF semiconductor device 100 and are electrically isolated from each other by a dielectric material. The conductive structures may be made of aluminum, copper or a copper alloy. The dielectric material may comprise an oxide or a nitride.

The redistribution layer 110 has a second side 120 opposite to the first side 112. A plurality of first solder balls 122 is arranged on the second side 120 of the redistribution layer 110. Accordingly, the redistribution layer 110 establishes the electrical connection between the plurality of first solder balls 122 and the semiconductor chip 102. A printed circuit board (PCB) which is not shown in Figure 1 may be electrically and mechanically mounted to the plurality of first solder balls 122. The plurality of first solder balls 122 may comprise at least one of Sn, Ag, or Cu. Each solder ball of the plurality of first solder balls 122 may have diameter in a range between 200 $\mu$m and 400 $\mu$m and pitches in a range between of 400 $\mu$m and 600 $\mu$m. In some examples, Flip-Chip BGAs (Ball Grid Arrays) or Wirebond-BGA may be used for establishing the electrical and mechanical connection to the PCB.

A metal layer 114 is disposed over the semiconductor chip 102 external to the active chip area. The metal layer 114 has a top surface 114a and a bottom surface 114b opposite to each other. The bottom surface 114b of the metal layer 114 faces the second surface 106 of the semiconductor chip 102. The metal layer 114 may have smooth or rough top surface 114a and bottom surface 114b, however a thickness of the metal layer 114 is always below than a skin depth of the metal layer 114 in the corresponding operating frequency range, wherein the thickness of the metal layer 114 is measured between the top 114a and bottom surface 114b in the vertical direction. In some examples, the thickness is selected such that the thickness of the metal layer 114 is along the extension of the metal layer 114 always below the skin depth.

The metal layer 114 may absorb the RF signals from the RF chip circuitry and thereby reduces the interference among the RF chip circuitry components, for example from one channel to another channel. In other words, the metal layer 114 reduces the RF signals reflecting back to the RF chip circuitry and hence improves the RF properties e.g., channel to channel isolation of the RF semiconductor device 100. The metal layer 114 may also absorb the RF signals originating from external elements and provides RF shielding to the RF semiconductor device 100 from the external elements.

The optimum performance of the RF semiconductor device 100 can be achieved by choosing the relevant thickness for the metal layer 114 depending upon the operating frequency of the RF semiconductor device 100 to be below the skin depth.

The improvement of the absorption properties of a metal layer is based on the skin depth effect, wherein the skin depth refers to how deeply the RF signal can penetrate the metal layer. When the RF signal passes through the metal layer it tends to become distributed within the metal layer such that an RF signal density is largest near a surface of the metal layer and decreases exponentially with greater depths in the metal layer. The skin depth depends on the frequency of the RF signal as well as the properties of the metal layer. The skin depth $\delta$ is calculated as

$$skin\ depth\ (\delta) = \sqrt{\frac{\rho}{\pi f \mu}}$$

where f is the frequency of the RF signal, $\rho$ is the resistivity of the metal layer and $\mu$ is the magnetic permeability of the metal layer.

In the RF semiconductor device 100, the metal layer 114 comprises a metal or a metal alloy e.g. Au, Al, Cu Ti, Ta, Ti, Ru, TaN, TiN, $Co_{90}Fe_{10}$, $Ni_{80}Fe_{20}$, $Ni_{60}Cr_{40}$ but not limited to the aforementioned examples. In general, the conductivity s of the metal layer depends on its thickness. The metal layer may have a thickness between 1nm and 150nm for maximum absorption in the first frequency range from 1 GHz to 500GHz. For ruthenium as an example, a thickness between 2.5nm and 10nm might be chosen to maximize the absorption for the second frequency range from 60GHz to 90GHz. With the introduction of the metal layer 114 on the semiconductor chip 102 a new concept is introduced which allows an efficient, cost effective and configurable absorption concept of RF signals for RF semiconductor devices. In particular, a proper selection of the metal layer 114 and further the thickness of metal layer 114 corresponding to the operating frequency range of the RF semiconductor device 100. The metal layer 114 can be deposited over the semiconductor device 102 using technology for e.g., sputter deposition or vapor deposition (PVD), evaporation, electrochemical deposition (ECD), Electroless deposition (ED), ALD, Metal film lamination. The new concept is inexpensive and highly flexible since an adaption of the absorption properties can be achieved by varying the thickness of the metal layer 114 for the requirement of various RF semiconductor devices. In particular, the thickness changes required for adaption of the absorption properties are within a nanometer or micrometer range which practically does not affect the device dimension which is in the millimeter range nor requires any additional steps or material. This makes the concept especially suitable for upcoming technologies and chip scaling in which more and more functionalities are integrated since the absorption can be easily varied and adapted for example in order to take into account the required operational frequency, the size or design of the RF semiconductor device, the routing of RF lines within the RF semiconductor device or the package type used. The concept can be used for single-chip RF devices or multi-chip RF devices in which multiple semiconductor chips are arranged above or lateral to each other within a semiconductor device. The metal layer 114 can extend completely over an area of the second main surface of the semiconductor chip 102 or at least a majority of the second main surface of the semiconductor chip 102. The metal layer 114 may in other examples be arranged to extend only over specific semiconductor chip areas of particular interest.

The new concept introduced in this application is further well-suited for fan-out packages where the RF signals are in a fan-out area significantly influenced by interference from other RF signals and will be described with respect to examples later in the description. In these examples, the metal layer 114 may extend in the complete fan-out area or in a majority of the fan-out area or in a portion of the fan-out area.

In some examples, the thickness of the semiconductor chip 102 may be in a range of a quarter wavelength of the RF signal. This configuration provides an additional advantage that the RF signals which are reflected at the second surface 106 will have 180° phase shift with respect to the RF signals originating at the RF chip circuitry and/or the first surface 104 and hence will vanish from destructive interference within the semiconductor chip 102 and thereby further reducing the interference among the RF chip circuitry components.

In some examples at least one antenna may be configured on the second surface 106 of the semiconductor chip 102 such that the at least one antenna is exposed and separated by a gap from the metal layer 114. Additionally, the metal layer 114 may reduce the interference between the at least one antenna.

Figure 2 shows an example of an RF semiconductor device 200 which may include some or all features of the RF semiconductor device 100 of Figure 1. The metal layer 114 is a first metal layer of a plurality of metal layers 216 (e.g. a stack of metal layers 216), wherein each metal layer of the plurality of metal layers 216 comprises a top surface 216a and a bottom surface 216b opposite to their respective top surface 216a. The plurality of metal layers 216 is arranged between the first surface 104 and second surface 106 of the semiconductor chip 102, wherein the bottom surface 216b of each metal layer of the plurality of metal layers 216 faces the second surface 106. Each metal layer of the plurality of metal layer 216 has a thickness that is below a skin depth corresponding to the operating frequency range of the semiconductor device 200, wherein the thickness of each metal layer of the plurality of metal layers 216 is measured between their respective top surfaces 216a and bottom surfaces 216b. Accordingly, each of the plurality of metal layers 216 provides the same properties and characteristics as outlined above for the metal layer 114 in order to improve the RF properties and reduce EMI. A material between the respective metal layers of the plurality of metal layers 216 may be a non-metallic material or a dielectric material, e.g. mold compound, silicon or silicon dioxide.

Each metal layer of the plurality of metal layers 216 may be separated by a distance in the range of quarter wavelength of the operating frequency range or a distance other than the quarter wavelength of the operating frequency range. The quarter wavelength separation among the plurality of metal layers 216 further improves the RF characteristics in that the RF signals reflected at each metal layer of the plurality of metal layers 216 will have 180° phase shift with respect to the RF signals reflected at the adjacent metal layer of the plurality of metal layer 216 and hence the RF signals will vanish due to destructive interference. The RF semiconductor device 200 combines the absorption, transmission and reflection properties of the plurality of metal layer 216.

In some examples, each metal layer in the plurality of metal layers 216 may comprise of a same metal or different metals. When plurality of metal layers 216 is comprised of different metals then RF signals of various frequencies may be absorbed.

Figure 3 shows an example of an RF semiconductor device 300 which may include some or all features of the RF semiconductor device 100 of Figure 1. The RF semiconductor device 300 is a fan-out package comprising a fan-out area. The fan-out package may be manufactured for example by an eWLB (embedded Wafer Level Ball Grid Array) process or other Fan-Out Wafer-Level-Packing technologies.

The RF semiconductor device 300 comprises a mold compound 302. The mold compound 302 covers completely or at least a portion of the second surface 106 and completely or at least a portion of the sidewalls 108 of the semiconductor chip 102 and a first portion of the first side 112 of the redistribution layer 110 that is not covered by the semiconductor chip 102. The mold compound 302 comprises an outer surface of the RF semiconductor device wherein the outer surface has a top side 304 and sidewalls 308. The top side 304 faces and extends beyond the second surface 106 of the semiconductor chip 102 and the fan-out area and the sidewalls 308 of the RF semiconductor device face the sidewalls 108 of the semiconductor chip 102. The mold compound 302 may be a low-loss mold compound with low-loss properties in the operating frequency range of the RF semiconductor device 300. At least a first region of the mold compound 302 may have a thickness in a range of 20 μm to 1000 μm, wherein the thickness of the first region is measured between the top side 304 of the RF semiconductor device 300 and the first side 112 of the redistribution layer 110 in the vertical direction. In other words, the at least first region is located in the fan-out area of the RF semiconductor device 300.

The low-loss properties of the mold compound 302 decreases the attenuation of the RF signal to be processed by the RF semiconductor device 300 in the fan-out area and makes the fan-out area prone to interference of RF signals. To improve the RF signal interference in such situations a first metal layer 314 is disposed over the top side 304 of the RF semiconductor device 300 wherein the first metal layer 314 faces the second surface 106 of the semiconductor chip 102 and the fan-out area and/or the sidewalls 308 of RF semiconductor device 300. The first metal layer 314 further faces the fan-out area and may absorb the RF signals in fan-out area and hence improving the channel-to-channel isolation in the fan-out area and other parts of the RF semiconductor device 300. The first metal layer 314 may in some examples be directly disposed and in contact with the top side 304 and/or sidewalls 308 of the RF semiconductor device 300. The first metal layer 314 has the same functionalities and characteristics as the metal layer 114 of RF semiconductor device 100.

In some examples, the thickness of at least the first region of the mold compound 302, measured in the fan-out-area, may be in the range of a quarter-wavelength of the operating frequency of the RF semiconductor device 300. The RF signals which are reflected at the top side 304 will have 180° phase shift with respect to the RF signals reflected from the second surface 106 of the semiconductor chip 102 or from the first side 112 of the redistribution layer 110 and hence the RF signals will vanish from destructive interference within the RF semiconductor device 300.

In some examples, the thickness of at least the first region of the mold compound 302 may be other than the quarter wavelength of the operating frequency range.

The mold compound 302 may be epoxy, filled epoxy, glass fiber filled epoxy, thermoset polymers, thermoplastic polymers, or elastomer polymers but not limited to the aforementioned examples.

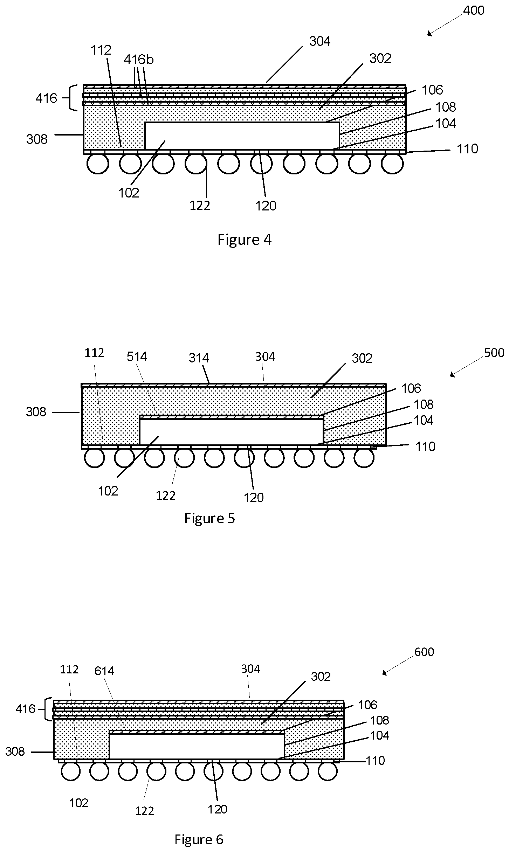

Figure 4 shows an example of an RF semiconductor device 400 which may include some or all features of the RF semiconductor device 200 of Figure 2 and the RF semiconductor device 300 of Figure 3. The first metal layer 314 is a metal layer of a plurality of metal layers 416, and the plurality of metal layers 416 has the same characteristics and functionalities and thicknesses as the plurality of metal layers 216 of the Figure 2. In one example, the plurality of metal layers 416 may be separated by a quarter wavelength of the operating frequency, as outlined above with respect to the plurality of metal layer 216.

The plurality of metal layers 416 may be arranged on the top side 304 of the RF semiconductor device 400, wherein the bottom surfaces 414b of each metal layer of the plurality of metal layers 416 faces and extends beyond the second surface 106 of the semiconductor chip 102 and the fan-out area. A material between the respective metal layers of the plurality of metal layers 416 may be a non-metallic material or a dielectric material, for e.g., mold compound, silicon or silicon dioxide. In some examples, each metal layer in the plurality of metal layers 416 and may comprise of different metal such that RF signals of various frequencies may be absorbed.

Figure 5 shows an example of an RF semiconductor device 500 which may include some or all features of the RF semiconductor device 300 of Figure 3. In addition to the first metal layer 314 extending over the top side 304 of the RF semiconductor device 500, the RF semiconductor device 500 comprises a second metal layer 514 similar to the metal layer 114 described above which is disposed over the second surface 106 of the semiconductor chip 102. The second metal layer 514 has the same functionalities and characteristics of the metal layer 114 of Figure 1. The first metal layer 314 on the top side 304 of the RF semiconductor device 500 absorbs the RF signals in the mold compound 302 and in the fan-out area, whereas the second metal layer 514 on the second surface 106 of the semiconductor chip 102 absorbs the RF signals within the semiconductor chip 102. The RF signals propagating in the RF semiconductor device 500 may scatter between the first metal layer 314 and the second metal layer 514 and eventually vanish.

Figure 6 shows an example of an RF semiconductor device 600 which may include some or all features of the RF semiconductor device 400 of Figure 4. In addition to the plurality of metal layers 416, the RF semiconductor device 600 further comprises a second metal layer 614 similar to the metal layer 114 which is disposed over the second surface 106 of the semiconductor chip 102. The second metal layer 614 has the same functionalities and characteristics of the metal layer 114 of Figure 1.

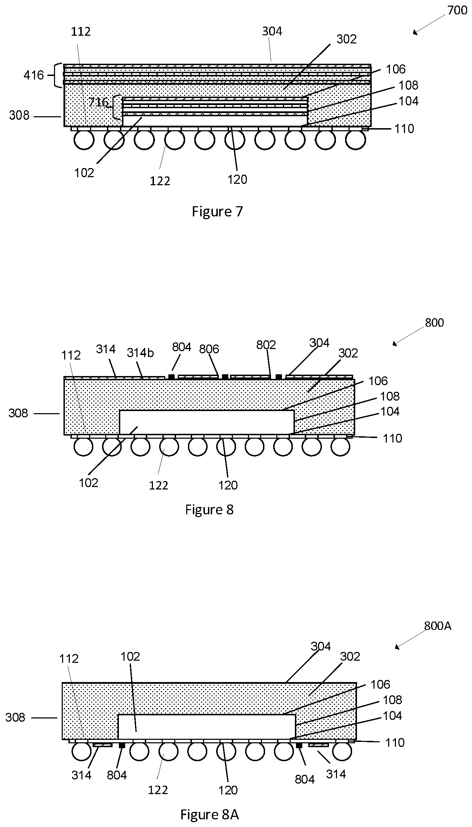

Figure 7 shows an example of an RF semiconductor device 700 which may include some or all feature of the RF semiconductor device 600 of Figure 6. A second plurality of metal layers 716 is provided in Figure 7 which includes the second metal layer 514. The second plurality of metal layers 716 is arranged between the first surface 104 and the second surface 106 of the semiconductor chip 102. The second plurality of metal layers 716 has the same functionalities and characteristics of the plurality of metal layers 216 of Figure 2.

Figure 8 shows an example of an RF semiconductor device 800 which may include some or all features of the RF semiconductor device 300 of Figure 3. In Figure 8, the first metal layer 314 is shown to include at least one recess 802. The at least one recess 802 may be a groove, a trench, a cut etc.

In some examples, the at least one recess 802 may be configured to accommodate an antenna 804 arranged on the top side 304 of the RF semiconductor device 800. The at least one antenna 804 may be configured to have a same horizontal level as of the bottom surface 314b of the first metal layer 314. The at least one antenna 804 is separated from the first metal layer 314 by a gap between the first metal layer 314 and the at least one antenna 804 in the lateral direction. The first metal layer 314 may absorb the RF signals and hence the interference originating from the at least one antenna 804 or between multiple of the at least one antenna can be reduced and tuned.

Figure 8A shows an example of an RF semiconductor device 800A which may include some or all features of the RF semiconductor device 800 of Figure 8. The RF semiconductor device 800A differs from the RF semiconductor device 800 regarding the position of the first metal layer 314 and the position of the at least one antenna 804. In Figure 8A, the first metal layer 314 and the at least one antenna 804 are arranged on the second side 120 of the redistribution layer 110. The first metal layer 314 is arranged in the fan-out area in the vicinity of the at least one antenna 804, wherein the first metal layer 314 may absorb the RF signal and reduce the interference originating from the at least one antenna 804 in the fan-out area.

In the RF semiconductor devices described in preceding examples, a heat sink can be mounted on the top side 304 of the RF semiconductor device 800. A thermal interface material can be arranged between the top side 304 of the RF semiconductor device and the heat sink. The thermal interface material may comprise for e.g., Gap Filler Pads, Dispensable Gap Fillers, Phase Change and having thermal conductivity in a range of 1 to 20 W/mK.

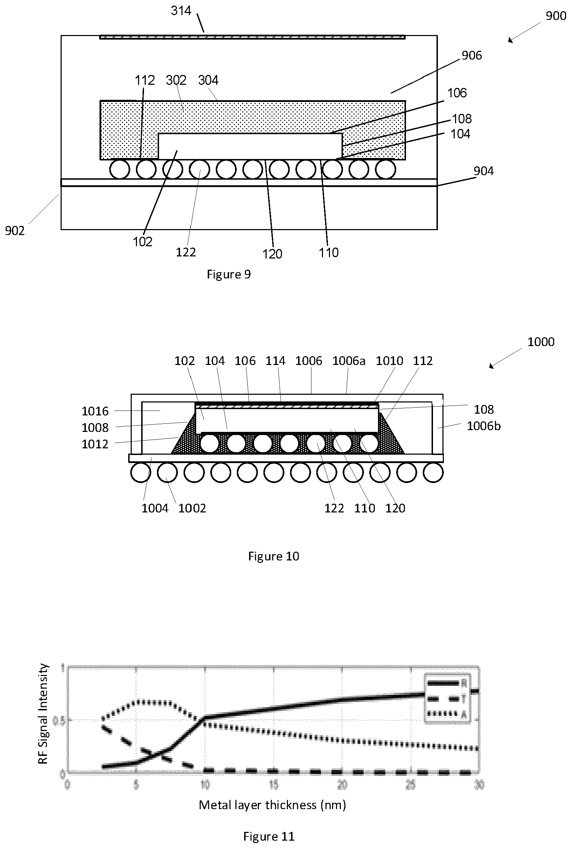

Figure 9 shows an example of an RF semiconductor device 900. The RF semiconductor device 900 comprises an RF semiconductor device 906, a printed circuit board 904 and a housing 902. The RF semiconductor device 906 is the RF semiconductor device 300 of Figure 300. The RF semiconductor device 906 is mechanically and electrically coupled to the printed circuit board 904 via the plurality of first solder balls 122. The RF semiconductor device 906 is enclosed by the housing 902, wherein the first metal layer 314 is arranged on a wall of the housing 902 facing the top side 304 of the RF semiconductor device 900. The housing 902 can be a metallic or plastic housing. For the location, where the antenna beam will radiate out of the radome housing, the material needs to be chosen in a way that the housing 902 is transparent.

Figure 10 shows an example of an RF semiconductor device 1000 which may include some or all features of the RF semiconductor device 100 of Figure 1. The RF semiconductor device 1000 comprises a plurality of second solder balls 1002, wherein the plurality of second solder balls 1002 faces the plurality of first solder balls 122. In the lateral direction, the plurality of second solder balls 1002 extends beyond the plurality of first solder balls 122. The plurality of second solder balls 1002 may comprise the same material and may have the same or different diameters and pitches as the plurality of first solder balls 122. A substrate 1004 is sandwiched between the plurality of first 122 and second solder balls 1002. The substrate 1004 may comprise of laminate or FR4 or Bismaleimide Triazine material, wherein the substrate 1004 may comprise a vertical or horizontal interconnects.

The RF semiconductor device 1000 further comprises a lid 1006, wherein the lid 1006 is a hollow structure having a main surface 1006a and side legs 1006b. The side legs 1006b are perpendicular to the main surface 1006a. The lid 1006 is mounted on the semiconductor chip 102 such that the main surface 1006a faces and extends beyond the second surface 106 having the metal layer 114. The side legs 1006b are mounted on the substrate 1004 and face the sidewalls 108 of the semiconductor chip 102. The side legs 1006b can be mounted to the substrate using an adhesive. A layer of thermal interface material 1010 is arranged between the metal layer 114 and a part of the main surface 1006a of the lid 1006 to provide mechanical and thermal stability between the semiconductor chip 102 and the lid 1006. The lid 1006 may comprise of a metal or a non-metal material and provides electrical shielding, thermal heat distribution and thermo-mechanical stability in the RF semiconductor device 1000. The metal and non-metal material may comprise a thermally conductive material.

An underfill material 1008 fully covers each solder ball in the plurality of first solder balls 122 and partially covers the sidewalls 108 of the semiconductor chip 102 and parts of the substrate 1004. A cavity 1016 is formed between an outer peripheral of the underfill compound 1008, the substrate 1004 and the lid 1006. The underfill material 1008 is a thermoset epoxy which reduces thermal stress occurring due to a mismatch of coefficient of thermal expansion between the substrate 1004 and the semiconductor chip 102.

In some examples the mold compound 302 may be arranged in the cavity 1016. The lid 1006 may be a flat lid comprising the main surface 1006a only. A layer of adhesive can be arranged between the main surface 1006a of the lid 1006 and the mold compound 302 increasing the adhesiveness between the lid 1006 and the mold compound 302.

In all of the above described examples, a metal layer having a thickness below the skin depth at the operating frequency is provided to improve the RF characteristic, in particular absorption.

Figure 11 shows a thickness dependence of transmission (T), reflection (R) and absorption (A) of the metal layer 114 comprising ruthenium (Ru) for a single operating frequency of 65 GHz. The metal layer 114 is deposited on the mold compound 302 during measurements and the thickness of the mold compound is 0.87 mm. The thickness of Ru is changed from 2.5 nm to 30 nm. Below 10nm thickness the absorption of Ru is higher than the reflection and the transmission due to the fact that the skin depth of Ru at 65 GHz is less than the 10 nm thickness. Such a situation is well suited to improve the RF characteristics and the EMI as absorption is high and reflection is low. As the thickness of the Ru increases beyond 10 nm thickness the skin depth effect is no longer effective and hence the reflection is higher than the absorption and the transmission.

The following examples pertain to further aspects of the disclosure:

Example 1 discloses a radio frequency (RF) semiconductor device to process RF signals in an operating frequency range comprising:

a semiconductor chip comprising a first surface, a second surface, sidewalls and an active chip region, the first surface and second surface extending along a lateral direction and the sidewalls extending along a vertical direction,

a metal layer external to the active chip region, wherein the metal layer faces the second surface of the semiconductor chip, wherein the metal layer has a thickness that is below a skin depth corresponding to the operating frequency range.

Example 2 discloses the RF semiconductor device according to example 1, wherein the metal layer is disposed on the second surface of the semiconductor chip.

Example 3 discloses the RF semiconductor device according to example 1 and 2, wherein the thickness of the semiconductor chip is in a range corresponding to a quarter-wavelength of the operating frequency range of the RF semiconductor device.

Example 4 discloses the RF semiconductor device according to example 1 and 2, wherein the RF semiconductor device comprises a plurality of metal layers, wherein the metal layer is a first metal layer of the plurality of metal layers, wherein the plurality of metal layers is arranged between the first surface and the second surface of the semiconductor chip, wherein the plurality of metal layers are external to the active chip region, wherein each metal layer of the plurality of metal layer has a thickness that is below a skin depth corresponding to the operating frequency range of the semiconductor device.

Example 5 discloses the RF semiconductor device according to any preceding example, wherein the semiconductor device further comprises a mold compound, wherein the mold compound covers at least a portion of the second surface and/or at least a portion of the sidewalls of the semiconductor chip.

Example 6 discloses the RF semiconductor device according to example 5, wherein the RF semiconductor device comprises a housing, wherein the metal layer is arranged between a wall of the housing and the second surface of the semiconductor chip.

Example 7 discloses the RF semiconductor device according to example 5, wherein the metal layer is a first metal layer, wherein the first metal layer is disposed over a top side of the RF semiconductor device facing the second surface of the semiconductor chip and/or a sidewall of the RF semiconductor device.

Example 8 discloses the RF semiconductor device according to example 7, wherein at least a first region of the mold compound has a thickness in a range of a quarter-wavelength of the operating frequency of the RF semiconductor device.

Example 9 discloses the RF semiconductor device according to example 7 or 8, wherein the first metal layer is a metal layer of a plurality of metal layers, wherein the plurality of the metal layers is arranged between the second surface of the semiconductor chip and the top side of the RF semiconductor device, wherein each metal layer of the plurality of metal layer has a thickness that is below a skin depth corresponding to the operating frequency range of the RF semiconductor device.

Example 10 discloses the RF semiconductor device according to example 7, wherein the first metal layer comprises at least one recess.

Example 11 discloses the RF semiconductor device according to example 10, wherein the semiconductor device comprises at least one antenna, wherein the at least one antenna is arranged in a recess of the metal layer, wherein the at least one antenna is separated from the metal layer by a gap.

Example 12 discloses the RF semiconductor device according to example 11, wherein the first metal layer and the at least one antenna are arranged on the second side of the redistribution layer.

Example 13 discloses the RF semiconductor device according to example 7 to 9, wherein a second metal layer is disposed on the second surface of the semiconductor chip, wherein the second metal layer has a thickness that is below the skin depth corresponding to the operating frequency range of the RF semiconductor device.

Example 14 discloses the RF semiconductor device according to example 9 wherein the RF semiconductor device comprises a second plurality of metal layer, wherein the second plurality of metal layers is arranged between the first surface and second surface of the semiconductor chip, wherein each metal layer of the plurality of metal layers has a thickness that is below a skin depth corresponding to the operating frequency range of the semiconductor device.

Example 15 discloses the RF semiconductor device according to example 5, wherein the RF semiconductor device comprises a housing, wherein the metal layer is arranged between a wall of the housing and the second surface of the semiconductor chip.

Example 16 discloses the RF semiconductor device according to any preceding example, wherein the RF semiconductor device comprises at least one of the following elements:

> a plurality of first solder balls arranged between the first surface and a substrate and a plurality of second solder balls arranged between the plurality of first solder balls and the substrate, an underfill compound covering fully a plurality of first solder balls, wherein the plurality first solder balls is arranged between the first surface and a substrate and wherein the underfill compound partially covers the sidewalls of the semiconductor chip; or a lid mounted on the second surface of the semiconductor chip, wherein the lid extends beyond the second surface of the semiconductor chip.

Example 17 discloses the RF semiconductor device according to any preceding example, wherein the metal layer has a thickness in a range of 0.5 nm to 100 nm.

Example 18 discloses a method for fabricating a radio frequency (RF) semiconductor device to process RF signals in an operating frequency range comprising:

> providing a semiconductor chip comprising a first surface, a second surface, side walls and an active chip region, the first surface and second surface extending along a lateral direction and the sidewalls extending along a vertical direction,

> providing a metal layer external to the active chip region, wherein the metal layer faces the second surface of the semiconductor chip, wherein the metal layer has a thickness that is below a skin depth corresponding to the operating frequency range.

**Claims**

1. A radio frequency (RF) semiconductor device (100) to process RF signals in an operating frequency range comprising:

> - a semiconductor chip (102) comprising a first surface (104), a second surface (106), sidewalls (108) and an active chip region, the first surface (104) and second surface (106) extending along a lateral direction and the sidewalls (108) extending along a vertical direction,
- a metal layer (114) external to the active chip region, wherein the metal layer (114) faces the second surface (106) of the semiconductor chip (102), wherein the metal layer (114) has a thickness that is below a skin depth corresponding to the operating frequency range.

2. The RF semiconductor device (100) according to claim 1, wherein the metal layer (114) is disposed on the second surface (106) of the semiconductor chip (102).

3. The RF semiconductor device (100) according to claim 1 and 2, wherein the thickness of the semiconductor chip (102) is in a range corresponding to a quarter-wavelength of the operating frequency range of the RF semiconductor device (100).

4. The RF semiconductor device (200) according to claim 1 and 2, wherein the RF semiconductor device (400) comprises a plurality of metal layers (216), wherein the metal layer (114) is a first metal layer of the plurality of metal layers (216), wherein the plurality of metal layers (216) is arranged between the first surface (104) and the second surface (106) of the semiconductor chip (102), wherein the plurality of metal layers (216) are external to the active chip region, wherein each metal layer of the plurality of metal layer (216) has a thickness that is below a skin depth corresponding to the operating frequency range of the semiconductor device (200)

5. The RF semiconductor device (300) according to any preceding claim, wherein the semiconductor device (300) further comprises a mold compound (302), wherein the mold compound (302) covers at least a portion of the second surface (106) and/or at least a portion of the sidewalls (108) of the semiconductor chip (102).

6. The RF semiconductor device (900) according to claim 5, wherein the RF semiconductor device comprises a housing (902), wherein the metal layer (114) is arranged between a wall of the housing (902) and the second surface (106) of the semiconductor chip (102).

7. The RF semiconductor device (300, 500, 800) according to claim 5, wherein the metal layer (114) is a first metal layer (314), wherein the first metal layer (314) is disposed over a top side (304) of the RF semiconductor device (300, 500, 800) facing the second surface (106) of the semiconductor chip (102) and/or a sidewall (308) of the RF semiconductor device (300, 500, 800).

8. The RF semiconductor device (300, 400, 500, 600, 700, 800) according to claim 7, wherein at least a first region of the mold compound (302) has a thickness in a range of a quarter-wavelength of the operating frequency of the RF semiconductor device (300, 400, 500, 600, 700, 800).

9. The RF semiconductor device (400) according to claim 7 or 8, wherein the first metal layer (314) is a metal layer of a plurality of metal layers (416), wherein the plurality of the metal layers (416) is arranged between the second surface (106) of the semiconductor chip (102) and the top side (304) of the RF semiconductor device (400), wherein each metal layer of the plurality of metal layer (416) has a thickness that is below a skin depth corresponding to the operating frequency range of the RF semiconductor device (400).

10. The RF semiconductor device (800) according to claim 7, wherein the first metal layer (314) comprises at least one recess (802).

11. The RF semiconductor device (800) according to claim 10, wherein the semiconductor device (1000) comprises at least one antenna (804), wherein the at least one antenna (804) is arranged in a recess (802) of the metal layer (114), wherein the at least one antenna (804) is separated from the metal layer (114) by a gap (806).

12. The RF semiconductor device (800A) according to claim 11, wherein the first metal layer (314) and the at least one antenna are arranged on the second side (120) of the redistribution layer (110).

13. The RF semiconductor device (500, 600, 700) according to claim 7 to 9, wherein a second metal layer (514) is disposed on the second surface (106) of the semiconductor chip (102), wherein the second metal layer (514) has a thickness that is below the skin depth corresponding to the operating frequency range of the RF semiconductor device (500, 600, 700).

14. The RF semiconductor device (700) according to claim 9 wherein the RF semiconductor device (700) comprises a second plurality of metal layer (716), wherein the second plurality of metal layers (716) is arranged between the first surface (104) and second surface (106) of the semiconductor chip (102), wherein each metal layer of the plurality of metal layers (716) has a thickness that is below a skin depth corresponding to the operating frequency range of the semiconductor device (700).

**15.** The RF semiconductor device according to any preceding claim, wherein the RF semiconductor device comprises a redistribution layer (110), wherein the redistribution layer (110) comprises a first side (112), wherein the first side (112) faces the first surface (104) of the semiconductor chip (102).

**16.** The RF semiconductor device according to any preceding claim, wherein a plurality of first solder balls (122) is arranged on a second side (120) of the redistribution layer (110) opposite to the first side (112).

**17.** The RF semiconductor device (1000) according to any preceding claim, wherein the RF semiconductor device comprises at least one of the following elements:

- a plurality of first solder balls (122) arranged between the first surface (104) and a substrate (1004) and a plurality of second solder balls (1002) arranged between the plurality of first solder balls (122) and the substrate (1004),
- an underfill compound (1008) covering fully a plurality of first solder balls (122), wherein the plurality first solder balls (122) is arranged between the first surface (104) and a substrate (1004) and wherein the underfill compound (1008) partially covers the sidewalls (108) of the semiconductor chip (102); or
- a lid (1006) mounted on the second surface (106) of the semiconductor chip (102), wherein the lid (1006) extends beyond the second surface (106) of the semiconductor chip (102).

**18.** The RF semiconductor device according to any preceding claim, wherein the metal layer has a thickness in a range of 0.5 nm to 100 nm.

**19.** A method for fabricating a radio frequency (RF) semiconductor device (100) to process RF signals in an operating frequency range comprising:

- providing a semiconductor chip (102) comprising a first surface (104), a second surface (106), sidewalls (108) and an active chip region, the first surface (104) and second surface (106) extending along a lateral direction and the sidewalls extending along a vertical direction,
- providing a metal layer (114) external to the active chip region, wherein the metal layer (114) faces the second surface (106) of the semiconductor chip (102), wherein the metal layer (114) has a thickness that is below a skin depth corresponding to the operating frequency range.

Figure 1

Figure 2

Figure 3

Figure 4

Figure 5

Figure 6

Figure 7

Figure 8

Figure 8A

314

900

906

112 302 304

106

108
104

904

902

102

122

120

110

Figure 9

1000

102 104 106 114 1006 1006a 1010 112

1016
1008
1012

108
1006b

1004 1002

122 110 120

Figure 10

RF Signal Intensity

R
T
A

0.5

0       5       10       15       20       25       30

Metal layer thickness (nm)

Figure 11

# EP 4 481 812 A1

Europäisches
Patentamt
European
Patent Office
Office européen
des brevets

## EUROPEAN SEARCH REPORT

Application Number

EP 23 18 0220

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/068831 A1 (BAE SOONHEUNG [KR] ET AL) 3 March 2022 (2022-03-03) | 1,5-11, 15-19 | INV. H01L23/552 |
| Y | * paragraph [0023] - paragraph [0025]; figure 5A * <br> * paragraph [0061] - paragraph [0063] * | 8,9 | ADD. H01L23/66 |
| X | US 2011/003435 A1 (TANG JINBANG [US] ET AL) 6 January 2011 (2011-01-06) | 1,5-11, 15-19 | |
| Y | * paragraph [0057] - paragraph [0060]; figures 16, 19 * <br> * paragraph [0065] - paragraph [0067] * | 8,9 | |
| X | US 2012/139091 A1 (WAKABAYASHI YOSHIAKI [JP]) 7 June 2012 (2012-06-07) | 1-3,17, 19 | |
| Y | * paragraph [0044] - paragraph [0050]; figure 1 * | 3 | |
| X | KR 2010 0082180 A (SAMSUNG ELECTRO MECH [KR]) 16 July 2010 (2010-07-16) | 1,5-11, 15-19 | |
| Y | * portion of the machine translation of the description relating to figs. 1-2; figure 2 * | 8,9 | TECHNICAL FIELDS SEARCHED (IPC) |
| X | US 2010/230789 A1 (YORITA CHIKO [JP] ET AL) 16 September 2010 (2010-09-16) | 1,5-11, 15-19 | H01L |
| Y | * paragraph [0088] - paragraph [0104]; figures 4, 11, 13 * <br> * paragraph [0111] - paragraph [0115] * | 8,9 | |
| Y | US 2017/025363 A1 (TSAI MING-HORNG [TW] ET AL) 26 January 2017 (2017-01-26) | 9 | |
| A | * paragraph [0030] - paragraph [0037]; figures 2B, 4D * | 1,5,7, 10,11, 15-19 | |

-/--

The present search report has been drawn up for all claims

| Place of search | Date of completion of the search | Examiner |
|---|---|---|
| Munich | 20 December 2023 | Hirsch, Alexander |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

15

Europäisches
Patentamt

European
Patent Office

Office européen
des brevets

## EUROPEAN SEARCH REPORT

Application Number

EP 23 18 0220

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2018/315719 A1 (KIM SEOKBONG [KR] ET AL) 1 November 2018 (2018-11-01)<br><br>* paragraph [0026]; figure 2 *<br>* paragraph [0040] *<br>----- | 1,5,7, 9-11, 15-19 | |
| Y | US 2007/132094 A1 (SHIMURA TOSHIHIRO [JP] ET AL) 14 June 2007 (2007-06-14) | 3,8 | |
| A | * paragraph [0010] – paragraph [0019]; figures 2A, 7, 8 *<br>* paragraph [0055] – paragraph [0057] *<br>* paragraph [0066] – paragraph [0073] *<br>----- | 6,17 | |

TECHNICAL FIELDS
SEARCHED        (IPC)

The present search report has been drawn up for all claims

| Place of search | Date of completion of the search | Examiner |
|---|---|---|
| Munich | 20 December 2023 | Hirsch, Alexander |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

Europäisches
Patentamt

European
Patent Office

Office européen
des brevets

**Application Number**

EP 23 18 0220

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

    **see sheet B**

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

    **1-3, 5-11, 15, 16, 18, 19(completely); 17(partially)**

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**
**SHEET B**

The Search Division considers that the present European patent application does not comply with the requirements of unity of invention and relates to several inventions or groups of inventions, namely:

1. claims: 1-3, 5-11, 15, 16, 18, 19(completely); 17(partially)

RF semiconductor devices comprising a semiconductor chip and comprising a metal layer for electromagnetic shielding, wherein the thickness of said metal layer is less than the skin depth at an operating frequency, wherein said metal layer may be positioned either directly on said semiconductor chip or on a molding layer which covers said semiconductor chip.
Further optional features comprising a redistribution layer and solder balls disposed on said semiconductor chip and underfill disposed between said semiconductor chip and a respective substrate.

1.1. claims: 9-11

The metal layer for electromagnetic shielding being provided on a molding layer as a multi-layer structure and/or the metal layer for electromagnetic shielding comprising recesses to accommodate antenna structures.

1.2. claim: 18

The metal layer for electromagnetic shielding having a thickness between 0.5 nm and 100 nm.

1.3. claim: 3

The thickness of the semiconductor chip being in a range of a quarter-wavelength of the operating frequency.

1.4. claim: 8

The thickness of a portion of the mold compound covering the semiconductor chip being in a range of a quarter-wavelength of the operating frequency.

1.5. claims: 6(completely); 17(partially)

A housing over and around the RF semiconductor device wherein the metal layer for electromagnetic shielding is provided between the semiconductor chip and the lid of the housing.
---

2. claims: 4, 13, 14

The metal layer for electromagnetic shielding being
- a multi-layer structure in or on the semiconductor chip and/or
- a metal layer on the semiconductor chip in combination

page 1 of 2

Europäisches
Patentamt

European
Patent Office

Office européen
des brevets

**LACK OF UNITY OF INVENTION
SHEET B**

Application Number

**EP 23 18 0220**

The Search Division considers that the present European patent application does not comply with the requirements of unity of invention and relates to several inventions or groups of inventions, namely:

```
        with a multi-layer metal structure on the mold compound over
        the chip and/or
        - a multi-layer metal structure in or on the semiconductor
        chip in combination with a multi-layer metal structure on
        the mold compound over the chip.
                        ---
```

```
    3. claim: 12
```

```
        The metal layer for electromagnetic shielding being provided
        over a redistribution layer over the first side of the
        semiconductor chip rather than over the mold compound over
        the second side of the semiconductor chip and there being an
        additional antenna arranged on said first side of the chip.
                        ---
```

```
    4. claim: 17(partially)
```

```
        Stacked solder balls between a first surface of the
        semiconductor chip and a respective substrate.
                        ---
```

```
Please note that all inventions mentioned under item 1, although not
necessarily linked by a common inventive concept, could be searched
without effort justifying an additional fee.
```

page 2 of 2

## ANNEX TO THE EUROPEAN SEARCH REPORT
## ON EUROPEAN PATENT APPLICATION NO.

EP 23 18 0220

This annex lists the patent family members relating to the patent documents cited in the above-mentioned European search report.
The members are as contained in the European Patent Office EDP file on
The European Patent Office is in no way liable for these particulars which are merely given for the purpose of information.

20-12-2023

| Patent document cited in search report | | | Publication date | Patent family member(s) | | Publication date |
|---|---|---|---|---|---|---|
| US 2022068831 | A1 | | 03-03-2022 | NONE | | |
| US 2011003435 | A1 | | 06-01-2011 | CN | 101971326 A | 09-02-2011 |
| | | | | KR | 20100057686 A | 31-05-2010 |
| | | | | US | 2009075428 A1 | 19-03-2009 |
| | | | | US | 2011003435 A1 | 06-01-2011 |
| | | | | WO | 2009035962 A2 | 19-03-2009 |
| US 2012139091 | A1 | | 07-06-2012 | CN | 102473690 A | 23-05-2012 |
| | | | | JP | WO2011021328 A1 | 17-01-2013 |
| | | | | US | 2012139091 A1 | 07-06-2012 |
| | | | | WO | 2011021328 A1 | 24-02-2011 |
| KR 20100082180 | A | | 16-07-2010 | NONE | | |
| US 2010230789 | A1 | | 16-09-2010 | CN | 101840910 A | 22-09-2010 |
| | | | | JP | 2010219210 A | 30-09-2010 |
| | | | | US | 2010230789 A1 | 16-09-2010 |
| US 2017025363 | A1 | | 26-01-2017 | US | 9461001 B1 | 04-10-2016 |
| | | | | US | 2017025363 A1 | 26-01-2017 |
| US 2018315719 | A1 | | 01-11-2018 | CN | 108807360 A | 13-11-2018 |
| | | | | US | 2018315719 A1 | 01-11-2018 |
| US 2007132094 | A1 | | 14-06-2007 | EP | 1826817 A1 | 29-08-2007 |
| | | | | EP | 2983203 A1 | 10-02-2016 |
| | | | | JP | 4947967 B2 | 06-06-2012 |
| | | | | JP | 2007165430 A | 28-06-2007 |
| | | | | US | 2007132094 A1 | 14-06-2007 |

EPO FORM P0459

For more details about this annex : see Official Journal of the European Patent Office, No. 12/82